Europäisches Patentamt

European Patent Office

Office européen des brevets

(11) Publication number: **0 175 017**
**B1**

# EUROPEAN PATENT SPECIFICATION

(45) Date of publication of patent specification: 28.12.88

(51) Int. Cl.⁴: **C 30 B 15/30**

(21) Application number: 84111307.9

(22) Date of filing: 21.09.84

(54) **Pulling-up device for single crystal of compound semiconductor containing volatile component.**

(43) Date of publication of application:
26.03.86 Bulletin 86/13

(45) Publication of the grant of the patent:
28.12.88 Bulletin 88/52

(84) Designated Contracting States:
DE FR GB IT

(56) References cited:
DE-A-2 306 754
US-A-3 481 711

INSTRUMENTS AND EXPERIMENTAL
TECHNIQUES, vol. 2, March/April 1966, pages
451; A.V. DUDENKOVA et al.: "An apparatus
for growing single crystals of unstable
semiconducting compounds"

(73) Proprietor: GAKEI ELECTRIC WORKS CO., LTD.
18-9, Senjyu-sakuragi 2-chome Adachi-ku
Tokyo (JP)

(72) Inventor: Nishizawa, Minoru
33-3, Seniyu-motomachi
Adachi-ku Tokyo (JP)

(74) Representative: Patentanwälte Viering &
Jentschura
Steinsdorfstrasse 6
D-8000 München 22 (DE)

## Description

Background of the Invention
Field of the Invention

The present invention relates to a pulling-up device for a single crystal of a compound semiconductor containing a volatile component as one constituent thereof such as gallium arsenide (GaAs), gallium phosphide (GaP), or indium phosphide (InP).

Description of the Prior Art

GaAs, GaP and InP melt at 1238°, 1470° and 1050°C and have dissociation pressures as high as 0.91, 30.4 and 15.7 bar (0.9, 30 and 15.5 atm) at such melting points respectively. Therefore, in pulling up single crystals of those compound semiconductors according to the Czochralski method, there has been developed a method in which not only the upper surface of a feed melt is covered with a liquid sealing agent such as, for example, $B_2O_3$ for preventing the evaporation of arsenic (As) or phosphorus (P), but also there is used an inert gas atmosphere of an extremely high pressure from several ten to several hundred atmospheres (1 atm $\triangleq$ 1,013 bar).

The feed melt usually is prepared by re-melting a polycrystal, but the method of preparing a feed melt directly from elemental components in the same production apparatus and subsequently pulling up a single crystal is more time-saving and so has often been tried. In this case, since the volatile components As and P have a vapor pressure which increases exponentially with rise of temperature there sometimes is used an inert gas atmosphere of a higher pressure in order to prevent the evaporation of such components.

On the other hand, in the case of pulling up a single crystal, it is necessary to rotate and vertically move a crucible which contains a feed melt and also rotate and vertically move a single crystal pulling-up shaft with a seed crystal attached to the fore end thereof. In this connection, in an apparatus for pulling up single crystals of such compound semiconductors as previously noted, it is a technical problem how smoothly a crucible supporting shaft and a single crystal pulling-up shaft are to be rotated and vertically moved without impairing the gas-tightness in the interior of a high pressure furnace.

Further, since the liquid level lowers with advancement of the single crystal pulling-up operation and it becomes impossible to see the interior of the crucible it is necessary to provide a device for measuring the weight of the single crystal being pulled up or that of the crucible in order to know to what extent the pulling-up operation had advanced, and it has also been a technical problem how such measuring device is to be incorporated in the pulling-up device.

It has been well known to use a drive means utilizing a magnetic force for transmitting a driving force from the exterior into an electric furnace which requires gas-tightness. However, such drive means all belong to a low pressure system, and the way of driving is either rotation or vertical movement. There has not been developed yet an effective means utilizing a magnetic force for transmitting a single shaft rotating and vertically moving drive force into an electric furnace (a high pressure vessel) which is held in a state of an extremely high pressure from several ten to several hundred bar.

It is a primary object of the present invention to provide a device for pulling up a single crystal of a compound semiconductor capable of transmitting both a rotation drive force and a vertical movement drive force to a crucible supporting shaft and a single crystal pulling-up shaft both positioned within a high pressure vessel (an electric furnace) held at an extremely high pressure without impairing at all the gas-tightness in the furnace.

It is another object of the present invention to provide a device for pulling up a single crystal of a compound semiconductor in which drive means for rotating and vertically moving a shaft enclosed in a cylinder of an extremely small diameter are disposed within the cylinder in an extremely efficient manner.

It is a further object of the present invention to provide a device for pulling up a single crystal of a compound semiconductor capable of measuring the weight of the single crystal or of a crucible without impairing at all the gas-tightness in a furnace despite of a high pressure in the furnace.

The invention is disclosed by the features as claimed.

The above and other objects, features and advantages of the invention will become clear from the following description of the preferred embodiment taken in conjunction with the accompanying drawings.

Brief Description of the Drawings

Fig. 1 is a schematic view illustrative of the present invention;

Fig. 2 is a longitudinal sectional view of a lower cylinder portion attached to an electric furnace;

Fig. 3 is a partial longitudinal sectional view of an upper cylinder portion attached to the electric furnace; and

Fig. 4 is a partially sectional view of the remaining portion of the upper cylinder attached to the electric furnace and of a weight measuring means.

Description of a Preferred Embodiment

An embodiment of the present invention will be described in detail hereinunder with reference to the accompanying drawings.

Fig. 1 is a schematic illustration of the present invention, in which a heating means 2 is provided in the interior of a pressure-resistant electric furnace 1 made of, for example, a stainless steel, and a crucible 3 is disposed in the interior of the heating means 2. The crucible 3 is put and fixed on a crucible supporting shaft 4. The crucible supporting shaft 4 is enclosed in a thin-walled lower cylinder 6 of a completely closed structure having a small diameter which is suspended hermetically downward from a holding cylinder 5 attached to a bottom cover 1a of the electric furnace 1, and it is adapted to be vertically moved and rotated by a drive means 7 for vertical movement and a drive means 8 for rotation both mounted inside and outside the lower cylinder 6 and utilizing a magnetic force. On the other hand, on a top cover 1b of the electric furnace 1 is erected a thin-walled upper cylinder 10 of a completely closed structure having a small diameter, with a weight measuring means 9 such as, for example, a load cell being attached to the upper portion of the cylinder 10. In the interior of the upper cylinder 10 is enclosed a single crystal pulling-up shaft 11, which is adapted to be rotated and vertically moved by a drive means 12 for rotation and a drive means 13 for vertical movement both mounted inside and outside the cylinder 10 and utilizing a magnetic force. A grown single crystal 15 of, for example, GaAs adheres to a seed crystal 14 fixed to the fore end of the single crystal pulling-up shaft 11 which is suspended to the upper portion of the crucible 3, and it is being pulled up from a GaAs feed melt 16 through a liquid sealing agent 17 of, for example, $B_2O_3$.

Referring now to Fig. 2, there is illustrated a drive mechanism, in which the lower cylinder comprises tubular bodies 6a and 6b which are axially opposed to each other and coupled hermetically and removably from each other by a coupling means 18. The coupling means 18 comprises a connecting pipe 19 for threadedly connecting the tubular bodies 6a and 6b, and clamp rings 20a and 20b which are threadedly fitted on the connecting pipe 19. By tightening the clamp rings 20a and 20b, packings 21a and 21b such as O-rings interposed between the connecting pipe 19 and the tubular bodies 6a and 6b are pressed down to isolate the interior of the tubular bodies 6a and 6b from the outside air. The tubular body 6b is attached to the holding cylinder 5 by fixing with bolts 22 a flange portion 6c formed at its upper end to a flange portion 5a of the holding cylinder 5 suspended from the bottom cover 1a, and the outside air is cut off by a packing 23 disposed between the flanges 6c and 5a. On the other hand, a plug 24 is fitted in the lower end of the tubular body 6a and is pressed by a cap nut 25 to provide a seal against the outside air.

In this way, the lower cylinder 6 is completely isolated from the outside air, so is held at the same pressure as that in the electric furnace 1. Even if this internal pressure is very high, the lower cylinder 6 can fully withstand it by being reduced in its diameter. The crucible supporting shaft 4 enclosed in the lower cylinder 6 comprises a vertically moving shaft 4a and a rotating shaft 4b, which are coupled together by, for example, a thrust ball bearing coupling 26 at the junction of the tubular bodies 6a and 6b.

Inside and outside the tubular body 6a is mounted the drive means 7 for driving the vertically moving shaft 4a. More specifically, inside the tubular body 6a is supported an inside magnet 29 rotatably by bearings 30 and 31 between a lower support cylinder 27 and an upper pressing cylinder 28 which are enclosed in the tubular body 6a, and an internal thread portion 29a formed in the inside magnet 29 is in engagement with an external thread portion 4c formed on the vertically moving shaft 4a. Further, a sliding key 32 is attached to the lower end portion of the vertically moving shaft 4a, and it is inserted into a guide slot 27a formed in an axial direction of the lower support cylinder 27. Usually, the internal thread portion 29a is formed separately from and attached to the inside magnet 29. The tubular body 6a is surrounded by an outside magnet 33 in an outside position opposed to the inside magnet 29. The outside magnet 33 is mounted rotatably between bearing members 36 and 37 mounted on the tubular body 6a, through ball bearings 34 and 35 which are mounted on lower and upper portions of the outside magnet. To a shaft portion of the outside magnet 33 is fixed a gear 38 which is rotated by a drive motor 39 through a drive force transmitting means 40 which comprises gears.

On the other hand, inside and outside the tubular body 6b is mounted the drive means 8 for rotating the rotating shaft 4b. More specifically, an inside magnet 41 is disposed inside the tubular body 6b. To the lower end portion of the inside magnet 41 is attached a rotating cylinder 42 having a guide slot 42a, while the upper end portion of the inside magnet 41 is supported through, for example, a ball bearing 44 by a holding cylinder 43 suspended from the upper portion of the tubular body 6b.

The rotating cylinder 42 is supported through, for example, a ball bearing 46 by a bearing member 45 which is fitted in the lower end portion of the tubular body 6b, and a sliding key 26a provided on the thrust ball bearing coupling 26 is inserted into the guide slot 42a, thus permitting the inside magnet 41 to rotate together with the rotating cylinder 42. The tubular body 6b is surrounded with an outside magnet 47 in an outside position opposed to the inside magnet 41, the outside magnet 47 being supported by bearing members 48 and 49 rotatably through ball bearings 50 and 51. To the upper end portion of the outside magnet 47 is fixed a gear 52, which is rotated by a drive motor 54 through a drive force transmitting means 53 which comprises gears.

Referring now to Figs. 3 and 4, there are illustrated the interior of the upper cylinder 10 and the weight measuring means 9, in which the upper cylinder 4 comprises tubular bodies 10a and 10b which are axially opposed to each other and coupled together hermetically and removably from each other by a coupling means 55. The coupling means 55 comprises a connecting pipe 56 for threadedly connecting the tubular bodies 10a and 10b, and clamp rings 57 and 58 which are threadedly fitted on the connecting pipe 56. By tightening the clamp rings 57 and 58, packing 59 and 60 such as O-rings interposed between the connecting pipe 56 and the tubular bodies 10a and 10b are pressed down to isolate the interior of the tubular bodies 10a and 10b from the outside air. The tubular body 10a is threadedly engaged at its lower end portion with a connecting cylinder 64 which is fixed by a clamp ring 62 hermetically through a packing 63 to a boss cylinder 61 erected on the top cover 1b of the electric furnace 1, and it is isolated from the outside air by a clamp ring 65 through a packing 66. To the upper end portion of the tubular body 10b is welded a base plate 67. On the base plate 67 is hermetically erected a thin-walled intermediate tubular body 10c of a small diameter by fixing a flange portion 10d welded to the fore end of the tubular body 10c to the base plate 67 with bolts 68 through a packing, the intermediate tubular body 10c being formed of the same material as the tubular body 10b. The upper end portion of the intermediate tubular body 10c is threadedly engaged with a connecting pipe 69 having a flange portion 69a and is sealed by tightening with a clamp ring 71 through a packing 70. To the flange portion 69a of the connecting pipe 69 is fixed with bolts 108 a flange portion 9a of the weight measuring means 9; and a packing 109 is interposed between the flange portions 69a and 9a to provide a seal against the outside air, as shown in Fig. 4.

Thus, the upper cylinder 10 is completely isolated from the outside air and is held at the same pressure as that in the electric furnace 1. Even if this internal pressure is very high, the upper cylinder 10 can fully withstand it by its reduced diameter.

The single crystal pulling-up shaft 11 enclosed in the upper cylinder 10 comprises a rotating shaft 11a and a vertically moving shaft 11b, which are coupled together by, for example, a thrust ball bearing coupling 72 at the junction of the tubular bodies 10a and 10b.

Inside and outside the tubular body 10a is mounted the drive means 12 for rotating the rotating shaft 11a. More specifically, in the interior of the tubular body 10a is disposed an inside magnet 73 with the rotating shaft 11a extending therethrough. On the upper end portion of the inside magnet 73 is fitted a rotating cylinder 74, while the lower end portion of the inside magnet 73 is supported by a support pipe 76 through, for example, a ball bearing means 77, the support pipe 76 being supported by a bearing means 75 provided on the inside bottom of the tubular body 10a. The rotating cylinder 74 is supported through a ball bearing 79 by a bearing cylinder 78 which is suspended from the upper end portion of the tubular body 10a, and it is rotatable together with the inside magnet 73. In the rotating cylinder 74 is formed a guide slot 74a, with which is inserted into a sliding key 80 attached to the rotating shaft 10a. The tubular body 10a is surrounded with an outside magnet 81 in an outside position opposed to the inside magnet 73. The outside magnet 81 is mounted rotatably between bearing members 84 and 85 mounted on the tubular body 10a, through ball bearings 82 and 83 which are mounted on lower and upper portions of the outside magnet. To a shaft portion of the outside magnet 81 is fixed a gear 86 which is rotated by a drive motor 87 through a drive force transmitting means 88 which comprises gears.

On the other hand, inside and outside the tubular body 10b is mounted the drive means 13 for driving the vertically moving shaft 11b. More specifically, an inside magnet 89 is disposed in the interior of the tubular body 10b. The inside magnet 89 is supported rotatably by a bearing means 91 such as, for example, a ball bearing provided between the inside magnet and a support cylinder 90 mounted on the inside bottom of the tubular body 10b, a bearing means 92 such as, for example, a ball bearing mounted on the upper portion of the inside magnet. The inside magnet 89 is formed with an internal thread portion 89a with which is engaged an external thread portion 11c formed on the vertically moving shaft 11b. The inside magnet 89 is surrounded with an outside magnet 93 in an outside position opposed to the inside magnet 89. The outside magnet 93 is supported by bearing members 94 and 95 mounted on lower and upper portions of the tubular body 10b, rotatably through bearings 96 and 97 such as, for example, ball bearings. On the upper end portion of the outside magnet 93 is mounted a gear 98 which is rotated by a drive motor 99 through a drive force transmitting means 100 which comprises gears.

On the upper end portion of the inside magnet 89 is erected a bearing cylinder 101 with the vertically moving shaft 11b extending therethrough, and as shown in Fig. 3, a suspending cylinder 103 is connected to the bearing cylinder 101 through, for example, a thrust ball bearing coupling 102. The suspending cylinder 103 is enclosed in a free state in the intermediate tubular body 10c, and as shown in Fig. 4, it is connected to the lower end portion of a suspended shaft 105 whose upper end is fixed to an elastic rod 104 of the weight measuring means 9. The suspending shaft 105 is enclosed in a free condition in the intermediate tubular body 10c. The suspending cylinder 103 is formed with an axially extending guide slot 103a, with which is engaged a sliding key 106 attached to the upper end of the vertically moving shaft 11b, and the suspending shaft 105 with the suspending cylinder 103 attached thereto is engaged through a sliding key 107 with a guide slot 69b formed in the connecting pipe 69.

Therefore, when the interior of the electric furnace 1 is filled with an inert gas of a high pressure, this pressure is applied to the interior of both upper and lower cylinders 10 and 6, but the gas-tightness is ensured because those cylinders are sealed as previously noted. Besides, even though the upper and lower cylinders 10 and 6 are thin-walled, they can fully withstand the internal pressure because they are of small diameter.

In operation, for vertically moving and rotating the crucible 3, the drive motor 39 is rotated, whereupon this rotational force is transmitted to the gear 38 through the drive force transmitting means 40 and the outside magnet 33 begins to rotate. Consequently, the inside magnet 29 begins to rotate by virtue of a magnetic force, and so the vertically moving shaft 4a with its external thread portion 4c engaged with the internal thread portion 29a, the rotation of which shaft 29a is prevented by the sliding key 32, moves up without rotating per se with rotation of the inside magnet 29 and moves down upon rotation of the drive motor 39 in the reverse direction. The vertical movements are transmitted through the thrust ball bearing coupling 26 to the rotating shaft 4b, so that the crucible 3 mounted on the upper end of the shaft 4b moves up and down in the interior of the heating means 2.

Next, upon rotation of another drive motor 54, its rotational drive force is transmitted to the gear 52 through the drive force transmitting means 53 and causes the outside magnet 47 to rotate. Then, this rotational force is transmitted to the inside magnet 41 through the thin-walled cylinder 6 by virtue of a magnetic force and causes the magnet 41 to rotate. Consequently, the rotating cylinder 42 also rotates, and the rotating shaft 4b engaged with the rotating cylinder 42 through the sliding key 26 rotates, thereby causing rotation of the crucible 3 mounted on its upper end. This rotational force is prevented from being transmitted to the vertically moving shaft 4a by the thrust ball bearing coupling 26. On the other hand, the vertical movements of the vertically moving shaft 4a are transmitted to the rotating shaft 4b, and so the shaft 4b also moves up and down, while its own rotation is not obstructed because the sliding key 26a is in engagement with the guide slot 42a formed in the rotating cylinder 42.

For rotating the single crystal pulling-up shaft 11, the drive motor 87 is turned ON, whereby the gear 86 is rotated via the drive force transmitting means 88 and the outside magnet 81 is also rotated. Consequently, a magnetic force is transmitted through the thin-walled upper cylinder 10 to the inside magnet 73, and this attractive force causes the inside magnet 73 to rotate, so that the rotating cylinder 74 is rotated together with the inside magnet 73, and the rotating shaft 11a with the sliding key 80 engaged with the guide slot 74a in the rotating cylinder also rotates. This rotational force is prevented from being transmitted to the vertically moving shaft 11 by the thrust ball bearing coupling 72.

For driving the vertically moving shaft 11b, the drive motor 79 is rotated. This rotation is transmitted to the gear 98 via the drive force transmitting means 100 and causes the outside magnet 93 to rotate, so that the inside magnet 89 rotates by virtue of a magnetic attraction as mentioned above, and the vertically moving shaft 11b with the external thread portion 11c engaged with the internal thread portion 89a formed in the inside magnet 89, the rotation of which shaft 11b is prevented by the engagement of the sliding key 106 with the guide slot 103a formed in the rotation-prevented suspending cylinder 103, moves up or down in accordance with the rotating direction of the outside magnet 93 without rotating per se.

Although the suspended cylinder 103 suspends the inside magnet 89, it does not rotate per se because not only it is connected through the thrust ball bearing coupling 102 to the bearing cylinder 101 which is attached to the inside magnet 89, but also the suspending shaft 105 with the suspending cylinder 103 connected thereto is engaged through the sliding key 107 with the guide slot 69a formed in the connecting cylinder 69. In this way, the single crystal pulling-up shaft 11 rotates and vertically moves to pull up a single crystal.

The means for measuring the weight of the single crystal being pulled up will now be explained. The suspending cylinder 103 is attached to the connecting shaft 105 which is connected to the elastic rod 104 of the weight measuring means 9, and the suspending cylinder 103 and the bearing cylinder 101 attached to the inside magnet 89 are coupled together through the thrust ball bearing coupling 102. The inside magnet 89 is suspended by the suspending cylinder 103 and is adapted to rotate in a vertically freely movable state. Therefore, the total weight, including the inside magnet 89, is measured through the vertically moving shaft 11b threadedly engaged with the internal thread portion 89a formed in the inside magnet 89, and the total weight of the related members is subtracted therefrom. The weight measuring means may be hermetically connected to the lower end side of the lower tubular body for measuring the weight of the crucible. In this case the suspending cylinder serves as a support cylinder for supporting the inside magnet.

**Claims**

1. A pulling-up device for a single crystal of a compound semiconductor containing a volatile component, including a pressure-resistant electric furnace, at least one thin-walled cylinder of a hermetically sealed structure having a small diameter and erected hermetically coaxially from said electric furnace, at least one moving shaft sealed in the interior of said cylinder, said moving shaft comprising a rotating portion and a vertically moving portion which are coupled together so that the rotation of either one does not affect the other, and drive means which utilize a magnetic force and which are disposed inside and outside said cylinder in positions corresponding to said rotating portion and vertically moving portion of said moving shaft, in which an inside magnet of the drive means disposed in the position corresponding to said rotating portion rotates a rotating cylinder connected thereto in an axial direction thereof and having an axially extending guide slot, said rotating portion being in engagement with said guide slot through a sliding key and being rotated together with said rotating cylinder, and an inside magnet of the drive means disposed in the position corresponding to said vertically moving portion having an internal thread portion engaged with an external thread portion formed on said vertically moving portion thereby allowing the vertically moving portion to move up and down with rotation of said inside magnet while its rotation is prevented by a sliding key.

2. A pulling-up device for a single crystal of a compound semiconductor containing a volatile component, including a pressure-resistant electric furnace according to claim 1, comprising a pair of thin-walled cylinders of a hermetically sealed structure having a small diameter and extending respectively in upward and downward directions from central portions of top and bottom covers of said electric furnace, a crucible supporting shaft, a single crystal pulling-up shaft, said crucible supporting shaft and said single crystal pulling-up shaft being respectively sealed in said paired cylinders and each comprising a rotating shaft and a vertically moving shaft which are coupled together so that the rotation of either one does not affect the other, and drive means which utilize a magnetic force and which are disposed inside and outside each of said paired cylinders in positions corresponding to said rotating shaft and said vertically moving shaft, in which an inside magnet of the drive means disposed in the position corresponding to said rotating shaft rotates a rotating cylinder provided in an axial direction thereof and having an axially extending guide slot, said rotating shaft being in engagement with said guide slot through a sliding key and being rotated together with said rotating cylinder, and an inside magnet of the drive means disposed in the position corresponding to said vertically moving shaft has an internal thread portion engaged with an external thread portion formed on said vertically moving shaft thereby allowing the vertically moving shaft to move up and down with rotation of said inside magnet while its rotation is prevented by a sliding key.

3. A pulling-up device for a single crystal of a compound semiconductor containing a volatile component according to claim 1 or 2, wherein said cylinder or cylinders each comprise a pair of tubular bodies which are axially opposed to each other and coupled together hermetically and removably from each other, said rotating portion or shaft and said vertically moving portion or shaft being enclosed respectively in said paired tubular bodies, and said drive means for driving said rotating portion or shaft and said vertically moving portion or shaft being disposed each inside and outside said tubular bodies in positions corresponding to said rotating portion or shaft and said vertically moving portion or shaft respectively.

4. A pulling-up device for a single crystal of a compound semiconductor containing a volatile component, including a pressure-resistant electric furnace, a pair of thin-walled cylinders of a hermetically sealed structure having a small diameter and extending respectively in upward and downward directions from central portions of top and bottom covers of said electric furnace according to one of claims 1 to 3, further comprising a weight measuring means attached hermetically to at least an upper one of said paired cylinders, a crucible supporting shaft, a single crystal pulling-up shaft, said crucible supporting shaft and said single crystal pulling-up shaft being sealed respectively in said paired cylinder, and means for suspending said single crystal pulling-up shaft sealed in the upper cylinder, said crucible supporting shaft as well as said single crystal pulling-up shaft and said suspending means being interconnected so that one is not affected by the rotation and vertical movement of the other and being enclosed in tubular bodies which are axially opposed to each other and coupled together hermetically and which constitute said cylinders.

5. A pulling-up device for a single crystal of a compound semiconductor containing a volatile component according to claim 4, wherein said suspending means suspends an inside magnet without being affected by the rotation of said inside magnet which is disposed around a vertically moving shaft.

6. A pulling-up device for a single crystal of a compound semiconductor containing a volatile component according to claim 4, wherein said weight measuring means is disposed on the side of the tubular body with said crucible supporting shaft sealed therein for measuring the weight of a crucible.

**Patentansprüche**

1. Ziehvorrichtung für einen Einkristall aus einer Halbleiterlegierung mit einer flüchtigen Komponente, mit einem druckfesten Elektroofen, mindestens einem dünnwandigen Zylinder, der eine hermetische abgedichtete Struktur aufweist und einen kleinen Durchmesser hat und der hermetisch und gleichachsig auf dem Ofen aufgebaut ist, mindestens einer innerhalb des Zylinders abgedichteten beweglichen Welle, wobei diese bewegliche Welle einen sich drehenden Teil und einem sich vertikal bewegenden Teil enthält, die so miteinander gekuppelt sind, daß die, Drehung jedes Teils auf den anderen nicht einwirkt, und Antriebsmitteln, die eine magnetische Kraft benutzen und die innerhalb bzw. außerhalb des Zylinders in Stellungen angeordnet sind, die dem sich drehenden Teil und dem sich vertikal bewegenden Teil entsprechen, wobei ein innerer Magnet der Antriebsmittel, der in einer dem sich drehenden Teil entsprechenden Stellung angeordnet ist, einen daran befestigten Drehzylinder dreht, der einen Führungsschlitz aufweist, wobei der sich drehende Teil über einen Gleitkeil in diesen Führungsschlitz eingreift und mit dem Drehzylinder mitgedreht wird, wobei ein innerer Magnet der Antriebsmittel, der in einer dem sich vertikal bewegenden Teil entsprechenden Stellung angeordnet ist, einen Innengewindeabschnitt aufweist, der in einen Außengewindeabschnitt an dem sich vertikal bewegenden Teil eingreift, wodurch der sich vertikal bewegende Teil durch die Drehung des inneren Magneten sich auf- und abbewegen kann, während seine Drehung von einem Gleitkeil verhindert wird.

2. Ziehvorrichtung für einen Einkristall aus einer Halbleiterlegierung mit einer flüchtigen Komponente, mit einem druckfesten Elektro-Ofen nach Anspruch 1, mit zwei dünnwandigen Zylindern, die eine hermetische abgedichtete Struktur aufweisen und einen kleinen Durchmesser haben und die sich zentral von einem unteren bzw. oberen Deckel des Elektroofens nach unten bzw. oben erstrecken, einer einen Schmelztiegel tragenden Welle, einer Einkristallziehwelle, wobei die den Schmelztiegel tragende Welle und die Einkristallwelle in dem jeweiligen Zylinder hermetisch adgedichtet sind und jeweils eine sich drehende Welle und eine sich vertikal bewegende Welle aufweisen, die so miteinander gekuppelt sind, daß die Drehung jeder Welle auf die andere nicht einwirkt, und Antriebsmitteln, die eine magnetische Kraft benutzen und außerhalb bzw. innerhalb der Zylinder in der sich drehende Welle und der sich vertikal bewegenden Welle entsprechenden Stellungen angeordnet sind, wobei ein innerer Magnet der Antriebsmittel, der in einer der sich drehenden Welle entsprechenden Stellung angeordnet ist, einen axial an ihm befestigten Drehzylinder dreht, der einen sich axial erstreckenden Führungsschlitz aufweist, in den die sich drehende Welle über einen Gleitkeil eingreift und sich gleichzeitig mit dem Drehzylinder dreht, wobei ein innerer Magnet der Antriebsmittel, der in einer der sich vertikal bewegenden Welle entsprechenden Stellung angeordnet ist, einen Innengewindeabschnitt hat, der in einen Außengewindeabschnitt der sich vertikal bewegenden Welle eingreift, wodurch die sich vertikal bewegende Welle durch die Drehung des inneren Magneten sich nach oben und unten bewegen kann, während ihre Drehung von einem Gleitkeil, verhindert wird.

3. Ziehvorrichtung für einen Einkristall aus einer Halbleiterleguerung mit einer flüchtigen Komponente nach Anspruch 1 oder Anspruch 2, wobei der Zylinder bzw, die Zylinder jeweils ein Paar Rohrkörper aufweist, die einander axial gegenüber stehen und die hermetisch und lösbar miteinander gekuppelt sind, wobei der sich drehende Teil bzw. die Welle und der sich vertikal bewegende Teil bzw. die sich vertikal bewegende Welle entsprechend in diesen beiden Rohrkörpern eingeschlossen sind und die Antriebsmittel zum Antreiben des sich drehenden Teils bzw. der sich drehenden Welle und des sich vertikal bewegenden Teils bzw. der sich vertikal bewegenden Welle jeweils außerhalb bzw. innerhalb der Rohrkörper in Stellungen angeordnet sind, die dem sich drehenden Teil bzw. der sich drehenden Welle und dem sich vertikal bewegenden Teil bzw. der sich vertikal bewegenden Welle entsprechen.

4. Ziehvorrichtung für einen Einkristall aus einer Halbleiterlegierung mit einer flüchtigen Komponente, nach einem der Ansprüche 1 bis 3, mit einem druckfesten Elektroofen, zwei dünnwandigen Zylindern, die eine hermetische Struktur aufweisen und einen kleinen Durchmesser haben und die sich zentral von einem unteren bzw. oberen Deckel des Elektroofens nach oben bzw. unten erstrecken, einer Gewichtsmeßeinrichtung, die mit mindestens einem oberen Zylinder der beiden Zylinder hermetisch verbunden ist, einer einen Schmelztiegel tragenden Welle, einer Einkristallziehwelle, wobei die den Schmelztiegel tragende Welle bzw. die Einkristallziehwelle in dem betreffenden der beiden Zylinder abgedichtet sind; und einem in dem oberen Zylinder abgedichteten Aufhängungsmittel für die Einkristallziehwelle, wobei die den Schmelztiegel tragende Welle die Einkristallziehwelle und das Aufhängungsmittel so miteinander verbunden sind, daß jedes Teil nicht durch die Drehung und die vertikale Bewegung der anderen Teile beeinflußt wird, und in Rohrkörpern eingeschlossen sind, die einander axial gegenüberstehen und die hermetisch miteinander gekuppelt sind und die Zylinder bilden.

5. Ziehvorrichtung für einen Einkristall aus einer Halbleiterlegierung mit einer flüchtigen Komponente, nach Anspruch 4, in der das Aufhängungsmittel einen inneren Magneten trägt, ohne daß die Drehung des inneren Magneten auf das Aufhängungsmittel einwirkt, wobei der innere Magnet rings einer sich vertikal bewegenden Welle angeordnet ist.

6. Ziehvorrichtung für einen Einkristall aus einer Halbleiterlegierung mit einer flüchtigen Komponente, nach Anspruch 4, in der die Gewichtsmeßeinrichtung auf der Seite des Rorkörpers mit der den Schmelztiegel tragenden Welle darin abgedichtet angeordnet ist, um das Gewicht eines Schmelztiegels zu messen.

## Revendications

1. Un dispositif de tirage pour un monocristal d'un composé semi-conducteur contenant une composante volatile, comprenant un four électrique résistant à la pression, au moins un cylindre à paroi mince d'une structure hermétiquement étanche présentant un faible diamètre et monté hermétiquement et coaxialement audit four électrique, au moins un arbre mobile disposé de façon étanche à l'intérieur dudit cylindre, ledit arbre mobile comprenant une partie rotative et une partie se déplaçant verticalement, qui sont couplées l'une à l'autre de façon que la rotation de l'une quelconque d'entre elles n'affecte pas l'autre, et des moyens d'entrainement qui utilisent une force magnétique et qui sont disposés à l'intérieur et à l'extérieur dudit cylindre dans des positions correspondant à ladite partie tournante et ladite partie mobile verticalement dudit arbre mobile, dans lesquels un aimant intérieur du moyen d'entraînement disposé dans la position correspondant à ladite partie tournante entraîne en rotation un cylindre rotatif qui lui est relié dans sa direction axiale et présentant une rainure de guidage s'étendant axialement, ladite partie en rotation étant en contact avec ladite rainure de guidage au moyen d'une clavette coulissante et étant entraînée en rotation avec ledit cylindre rotatif, et un aimant intérieur du moyen d'entraînement disposé dans la position correspondant à ladite partie mobile verticalement comportant une partie filetée intérieure passée sur une partie filetée extérieur formée sur ladite partie mobile verticalement, permettant ainsi à la partie mobile verticalement de monter et de descendre par la rotation dudit aimant intérieur tandis que sa rotation est empêchée par une clavette coulissante.

2. Un dispositif de tirage pour un monocristal d'un composé semi-conducteur contenant une composante volatile, comprenant un four électrique résistant à la pression, selon la revendication 1, constitué d'une paire de cylindres à paroi mince, à structure étanche hermétiquement et de faible diamètre et s'étendant respectivement vers le haut et vers le bas à partir de parties centrales des couvercles supérieur et inférieur dudit four électrique, un arbre support de creuset, un arbre de tirage de monocristal, ledit arbre support de creuset et ledit arbre de tirage de monocristal étant respectivement disposés de façon étanche dans ladite paire de cylindres et constitués chacun d'un arbre tournant et d'un arbre mobile verticalement qui sont accouplés l'un à l'autre de façon que la rotation de l'un quelconque d'entre eux n'affecte pas l'autre, et des moyens d'entraînement qui utilisent une force magnétique et qui sont disposés à l'intérieur et à l'extérieur de chacun des deux cylindres dans des positions correspondant audit arbre rotatif et audit arbre mobile verticalement, dans lesquels un aimant intérieur du moyen d'entraînement disposé dans la position correspondant audit arbre rotatif entraîne en rotation un cylindre rotatif disposé dans sa direction axiale et présentant une rainure de guidage s'étendant axialement, ledit arbre rotatif étant en contact avec ladite rainure de guidage par une clavette coulissante et étant entraîné en rotation avec ledit cylindre rotatif, et un aimant intérieur du moyen d'entraînement disposé dans la position correspondant audit arbre mobile verticalement présente une partie filetée intérieure vissé sur une partie filetée extérieure formée sur ledit arbre mobile verticalement, permettant ainsi à l'arbre mobile verticalement de monter et de descendre par la rotation dudit aimant intérieur tandis que sa rotation est empêchée par une clavette coulissante.

3. Un dispositif de tirage pour un monocristal d'un composé semi-conducteur contenant une composante volatile, selon la revendication 1 ou la revendication 2, dans lequel ledit cylindre ou lesdits cylindres est (on sont) constitué(s) chacun d'une paire de corps tubulaire qui sont opposés axialement l'un à l'autre et qui sont couplés l'un à l'autre de façon hermétique et amovible, ladite partie ou ledit arbre tournant et ladite partie ou ledit arbre mobile verticalement étant disposés respectivement dans lesdits corps tubulaires par paire, et lesdits moyens d'entraînement pour entraîner ladite partie ou ledit arbre en rotation et ladite partie ou ledit arbre mobile verticalement étant disposés chacun à l'intérieur et à l'extérieur desdits corps tubulaires dans des positions correspondant respectivement à ladite partie ou audit arbre tournant et à ladite partie ou audit arbre mobile verticalement.

4. Un dispositif de tirage pour un monocristal d'un composé semi-conducteur contenant une composante volatile, comprenant un four électrique résistant à la pression, une paire de cylindres d'une structure hermétiquement étanche et de faible diamètre et s'étendant respectivement vers le haut et vers le bas, à partir des parties centrales des couvercles supérieur et inférieur dudit four électrique, selon l'une des revendications 1 à 3, comprenant en outre un dispositif de mesure de poids fixe hermétiquement à au moins le cylindre supérieur desdits deux cylindres, un arbre support de creuset, un arbre de tirage de monocristal, ledit arbre support de creuset et ledit arbre de tirage de monocristal étant disposés de façon étanche respectivement dans lesdits deux cylindres, et des moyens de suspension dudit arbre de tirage de monocristal disposé de façon étanche dans le cylindre superieur, ledit arbre de support de creuset ainsi que l'arbre de tirage de monocristal et ledit moyen de suspension étant reliés entre eux de façon que l'un ne soit pas affecté par la rotation et le déplacement vertical de l'autre, et étant disposés à l'intérieur des corps tubulaires qui sont axialement opposés l'un à l'autre et accouplés ensemble hermétiquement et qui constituent lesdits cylindres.

5. Un dispositif de tirage pour un monocristal d'un composé semi-conducteur contenant une composante volatile, selon la revendication 4, dans lequel lesdits moyens de suspension supportent un aimant intérieur sans être affectés par la rotation dudit aimant intérieur qui est disposé, autour d'une arbre mobile verticalement.

6. Un dispositif de tirage pour un monocristal d'un composé semi-conducteur contenant une composante volatile selon la revendication 4, dans lequel ledit dispositif de mesure de poids est disposé sur le côté du corps tubulaire avec ledit arbre de support de creuset disposé de façon étanche à l'intérieur de celui-ci pour mesurer le poids du creuset.